Europäisches Patentamt

European Patent Office

Office européen des brevets

(11) Numéro de publication: **0 267 836 B1**

# FASCICULE DE BREVET EUROPEEN

(45) Date de publication de fascicule du brevet: **29.04.92**　(51) Int. Cl.⁵: **H03M 13/00**, G06F 7/60

(21) Numéro de dépôt: **87402386.4**

(22) Date de dépôt: **23.10.87**

(54) **Codeur-décodeur algébrique de codes en blocs Reed Solomon et BCH, applicable aux télécommunications numériques.**

(30) Priorité: **27.10.86 FR 8614925**

(43) Date de publication de la demande:
**18.05.88 Bulletin 88/20**

(45) Mention de la délivrance du brevet:
**29.04.92 Bulletin 92/18**

(84) Etats contractants désignés:
**DE GB IT**

(56) Documents cités:
**EP-A- 0 165 147
EP-A- 0 169 908
US-A- 3 533 067
US-A- 4 162 480**

**PROCEEDINGS OF SPIE - THE INTERNATIO-
NAL SOCIETY FOR OPTICAL ENGINEERING,
vol. 421, "Optical Disks Systems and Applications", Arlington, Virginia, 8-9 juin 1983,
pages 65-78, SPIE-The International Society
for Optical Engineering, Bellingham, Washington, US; SHIRISH DEODHAR et al.: "High
speed interleaved Reed-Solomon error detection and correction system"**

**IEEE TRANSACTIONS ON COMPUTERS, vol.
C-34, no. 8, août 1985, pages 709-717, IEEE,
New York, US; C.C. WANG et al.: "VLSI architectures for computing multiplications and
inverses in GF(2m)"**

(73) Titulaire: **THOMSON-CSF
51, Esplanade du Général de Gaulle
F-92800 Puteaux(FR)**

(72) Inventeur: **Brechard, Dominique
THOMSON-CSF SCPI 19, avenue de Messine
F-75008 Paris(FR)**
Inventeur: **Laurent, Pierre André
THOMSON-CSF SCPI 19, avenue de Messine
F-75008 Paris(FR)**

(74) Mandataire: **Turlèque, Clotilde et al
THOMSON-CSF SCPI
F-92045 PARIS LA DEFENSE CEDEX 67(FR)**

## Description

L'invention se rapporte au domaine des télécommunications numériques et plus particulièrement à un circuit codeur-décodeur algébrique de codes en blocs, Reed Solomon et BCH, utilisable en télécommunications.

Les télécommunications numériques sont soumises à des perturbations dues, entre autres, à la faible qualité du canal de transmission ou à l'intervention de brouilleurs actifs. De ce fait, il est nécessaire d'assurer une protection efficace de l'information.

Les méthodes classiques associent une détection d'erreur simple, parité etc, et une procédure de répétition des messages. Ces méthodes peuvent être avantageusement remplacées par la technique des codes correcteurs d'erreurs qui permettent de réaliser un bon compromis entre le débit utile et la sécurité des données transmises. Le problème qui limite l'utilisation de ces codes correcteurs d'erreurs est lié à la complexité de leur mise en oeuvre. En effet l'implantation de ce type de codes sur des microprocesseurs généraux ou de traitement de signal n'autorise que des applications à faible débit. En effet le codage et le décodage font appel à des traitements de polynômes à valeurs dans les corps de Galois auxquels ces processeurs classiques sont mal adaptés.

Le document EP-A-0 165 147 au nom de la Demanderesse décrit un circuit codeur-décodeur de codes en blocs, paramétrable, utilisable dans les télécommunications numériques pour traiter les données par les codes correcteurs d'erreurs indiqués ci-dessus. Le codeur-décodeur décrit dans cette demande est un circuit monolithique de préférence, périphérique intelligent d'un microprocesseur qui permet d'atteindre des débits de plusieurs dizaines de kilobits par seconde avec des taux d'erreurs élevés dans le canal de transmission. Ce circuit standard est capable de traiter tous les codes usuels des familles de codes cités précédemment dans leurs différentes versions et sans aucune intervention du microprocesseur hôte autre que la définition des codes utilisés et la gestion des opérations entrées et sorties. Cependant, le circuit codeur-décodeur décrit dans la demande en référence et prévu de manière générale conduit à un niveau de complexité important sans permettre toutefois de traiter les polynômes dans le corps de Galois CG(256) qui est seul susceptible de traiter directement les octets, c'est-à-dire l'information dans la forme où elle se présente généralement.

L'invention a pour objet un codeur-décodeur de codes en blocs tel que décrit dans la revendication 1 et comportant des améliorations majeures par rapport au dispositif décrit précédemment qui permettent l'intégration du circuit sous forme monolithique, le circuit pouvant alors atteindre des performances élevées du fait notamment de la simplification des chemins critiques, de la diminution du temps de cycle, et de la puissance de calcul de ce circuit spécialisé.

L'invention sera mieux comprise et d'autres caractéristiques apparaîtront à l'aide de la description qui suit en référence aux figures annexées:

- La figure 1 est un schéma synoptique d'ensemble du codeur-décodeur selon l'invention ;
- La figure 2 est un schéma plus détaillé de l'opérateur arithmétique, 300, de la figure1 ;
- La figure 3 est un schéma plus détaillé de l'opérateur Galois, 400, de la figure 1 ;
- La figure 4 est un schéma plus détaillé du circuit d'interface, 500, de la figure1 ;
- La figure 5 est un schéma plus détaillé du circuit de commande, 100, de la figure1 ;
- Les figures 6, 7, 8 et 9 sont des chronogrammes représentant les signaux générés respectivement dans le générateur d'horloge 200, dans l'opérateur arithmétique, 300, dans l'opérateur Galois 400, et dans le circuit d'interface 500.

Le processeur spécialisé pour réaliser les codages et décodages de codes de blocs BCH ou Reed Solomon comporte, comme celui décrit dans la demande de brevet indiquée ci-dessus, un circuit d'interface pour gérer les transferts avec le microprocesseur hôte, un circuit séquenceur qui gère l'exécution des instructions et les transferts de données, une mémoire de programme, un opérateur arithmétique et un opérateur traitant les valeurs dans les corps de Galois.

Mais suivant l'invention et comme il sera décrit plus en détails ci-après en référence aux figures annexées, le séquenceur du dispositif comporte un système de boucle automatique pour la gestion des algorithmes polynomiaux. Par contre il ne permet pas de traiter des sous-programmes qui sont ici superflus du fait du fonctionnement de l'ensemble du circuit codeur-décodeur. L'opérateur arithmétique quant à lui est réduit au strict nécessaire pour assurer la paramétrabilité des algorithmes et comprend une mémoire RAM, une unité arithmétique et logique UAL et un accumulateur. L'opérateur Galois comporte deux mémoires en parallèle pilotées par une unité d'adressage puissante, et un opérateur polynomial dans les corps de Galois optimisé pour permettre l'exécution des traitements polynomiaux nécessaires dans les algorithmes de codage et décodage les plus généraux par l'exécution d'une micro-instruction toujours semblable à elle-même. Enfin le circuit codeur-décodeur présente un mode d'entrées/sorties dont la structure complexe qui associe un dispositif de mémoire géré en FIFO (First In, First Out selon la terminologie anglo-saxonne) construit autour des deux mémoires principales du circuit et une procédure rapide de vol de cycle affectant toutes les fonctions du
processeur, offre une grande souplesse de communication avec le processeur hôte. Ce circuit est
donc conçu comme un périphérique spécialisé du
processeur hôte auquel il est associé.

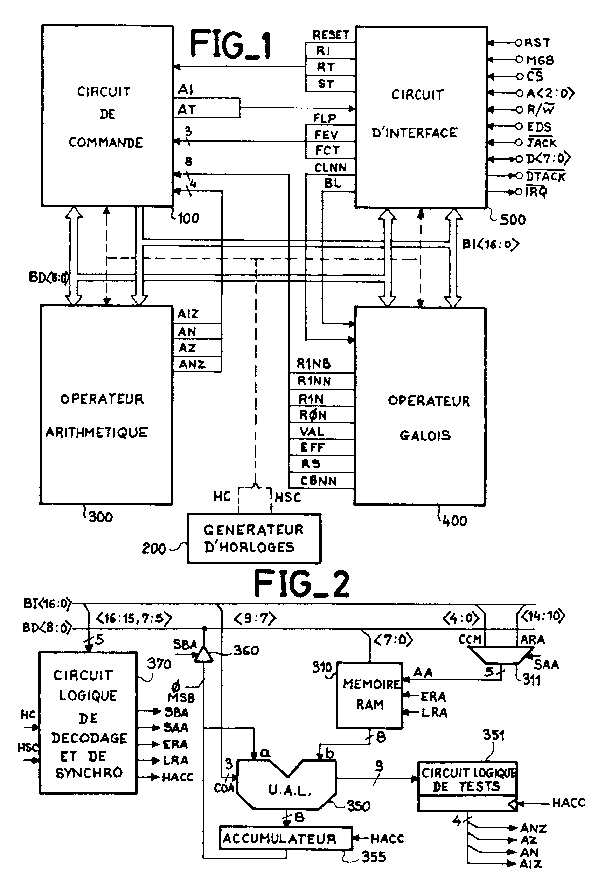

La figure 1 représente le schéma synoptique
d'ensemble de ce processeur spécialisé dans le
codage et le décodage du code en blocs et comporte des modules qui communiquent d'une part
par un bus de données de neuf bits, BD<8:0>, et
d'autre part par un bus d'instruction de 17 bits,
BI<16:0>. Ces m les suivants:

- un circuit de commande 100, qui commande
  l'ensemble du circuit par le bus d'instruction
  BI et le circuit d'interface par deux signaux AI
  et AT, en fonction du programme en cours
  d'exécution, des données présentes sur le
  bus de données BD, de signaux prioritaires
  RI, RT, de signaux de test conditionnels
  (FLP, FEV et FCT) décrits plus en détails ci-
  après issus du circuit d'interface, d'un mot
  d'état de 4 bits issu de l'opérateur arithmétique et un mot d'état de 8 bits issu de l'opérateur Galois;

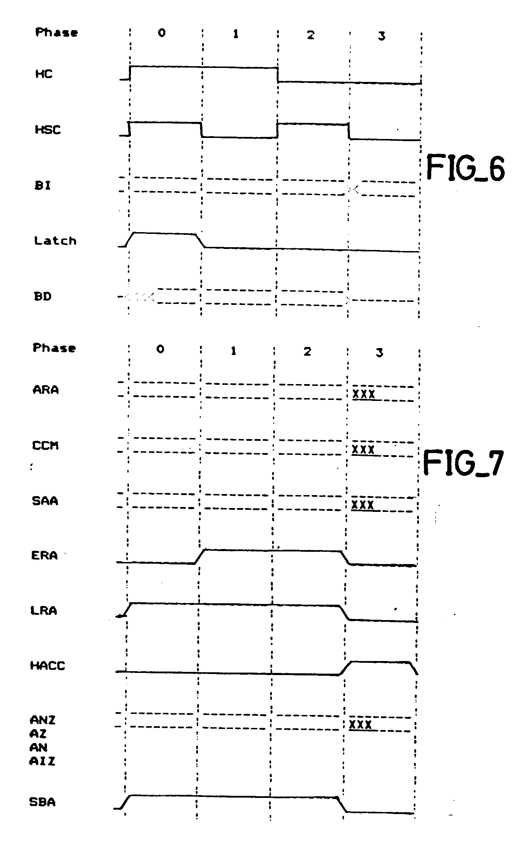

- un générateur d'horloge 200, qui délivre une
  horloge cycle HC et une horloge "sous cycle" HSC de période moitié de l'horloge HC
  qui définissent quatre phases par cycle. Ces
  deux signaux représentés sur la figure 6 rythment le fonctionnement du processeur.

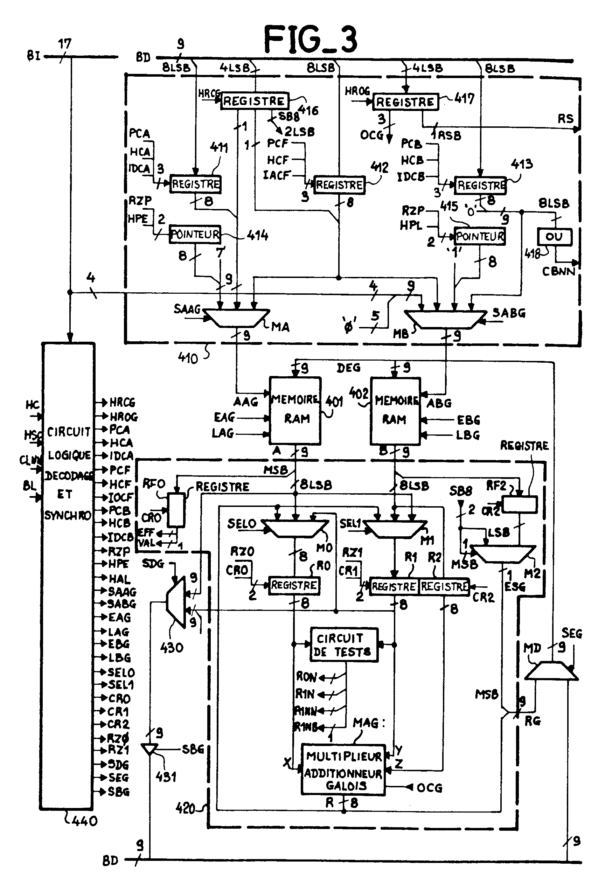

- un opérateur arithmétique 300 qui traite les
  valeurs arithmétiques nécessaires aux algorithmes: paramètres de programmation, variables de programme, adresses mémoire ... Ce
  module est décrit plus en détails ci-après en
  référence à la figure 2; il fournit le mot d'état
  de 4 bits (AIZ, AN, AZ, ANZ) au circuit de
  commande100.

- un opérateur Galois 400 qui stocke les données des mots de code et réalise les opérations polynomiales propres aux algorithmes
  de traitement des codes dans les corps de
  Galois. Ce module est décrit plus en détails
  ci-après en référence à la figure 3; il fournit
  en outre le mot d'état de 8 bits (R1NB,
  R1NN, R0N, VAL, EFF, RS et CBNN) au
  circuit de commande 100.

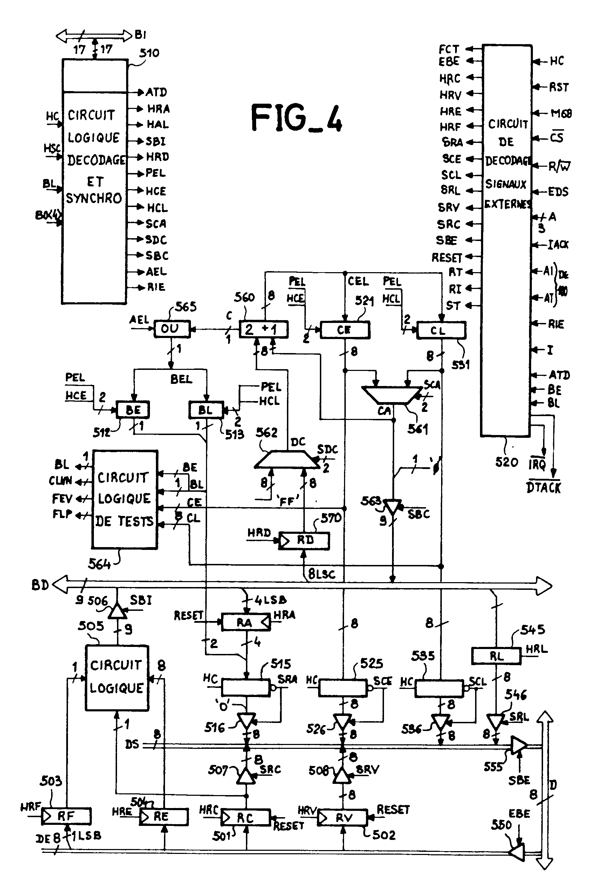

- un circuit d'interface 500 qui gère les
  entrées/sorties avec un processeur extérieur
  via un bus de données extérieur de 8 bits,
  D<7:0> et des signaux extérieurs précisés ci-
  après. Ce circuit est décrit plus en détails en
  référence à la figure 4.

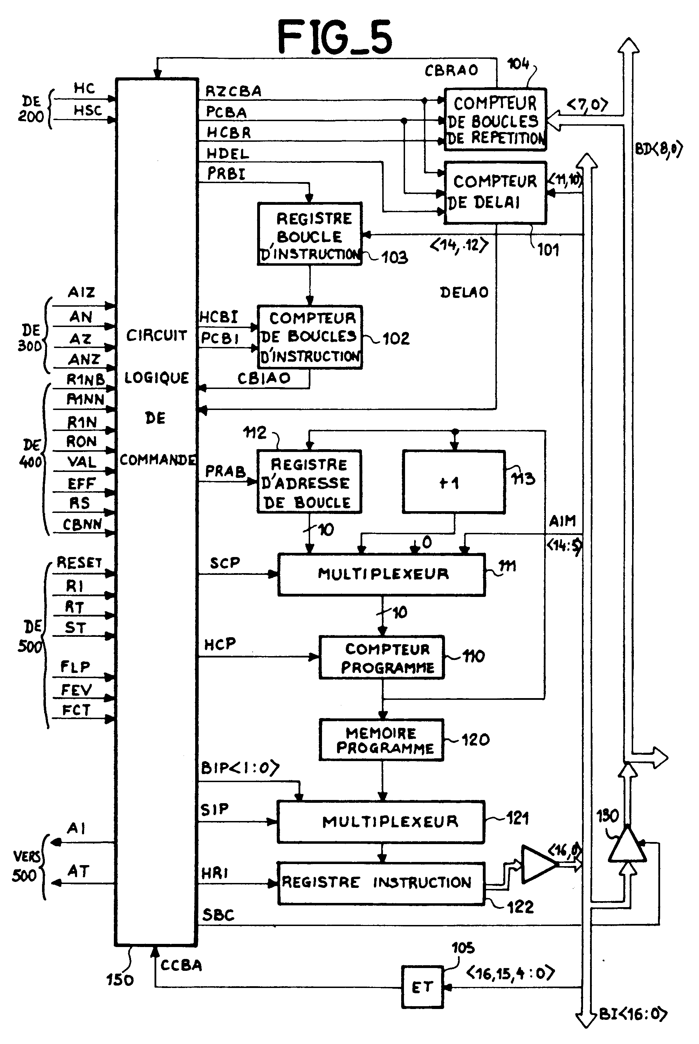

Le circuit de commande 100 qui gère l'ensemble est décrit plus en détails ci-après en référence
à la figure 5.

L'opérateur arithmétique 300 de la figure 1
représenté plus en détails sur la figure 2 réalise les
traitements arithmétiques et logiques sur les paramètres des codes, les variables de gestion des
algorithmes, et les adresses calculées de polynômes présents dans les mémoires Galois définies
ci-après. Pour une adaptation exacte du processeur
à ces traitements, ces fonctions ne justifient qu'une
structure d'opérateur simple. Il comporte une mémoire de faible capacité 310, une unité arithmétique et logique, UAL, 350, qui réalise des fonctions
arithmétiques et logiques élémentaires sur deux
opérandes appliquées à ses entrées a et b, et un
registre accumulateur 355 relié à la sortie de l'unité
arithmétique et logique 350 qui permet de cumuler
une série d'opérations simples, par exemple dans
le but de fournir des adresses à l'opérateur Galois
ou de disposer de signaux de tests conditionnels
pour orienter le séquencement dans le circuit de
commande 100. La mémoire 310 de l'opérateur
arithmétique dans laquelle les données sont stockées est une mémoire RAM de 32 mots de huit
bits dont l'adresse AA est issue directement de
l'instruction exécutée par prélèvement sur le bus
d'instruction BI via un multiplexeur 311 qui choisit
comme adresse appliquée à l'entrée AA de la
mémoire RAM un champ instruction fonction du
type d'instruction exécuté (soit dans l'exemple représenté les 5 premiers bits ou les 5 derniers bits
du mot de 17 bits transmis par le bus d'instruction
BI) sur commande extérieure appliquée au multiplexeur 311 SAA. L'entrée de données de cette
mémoire est connectée aux huit bits de faible
poids LSB du bus de données BD, et sa sortie est
reliée à une entrée multiple sur huit bits, b de
l'unité arithmétique et logique. Deux signaux de
commande ERA et LRA commandent l'écriture et
la lecture dans cette mémoire.

Les opérations simples, non signées, sont effectuées par l'unité arithmétique et logique, 350,
suivant les différents codes opérations définis par
un champ COA de trois bits prélevé sur le bus
d'instruction BI et qui permet, sur les opérandes $\overline{a}$
issu du registre accumulateur 355 et $\overline{b}$ issu de la
mémoire RAM 310, les opérations suivantes :
  . l'addition sans signe a + b;
  . la soustraction sans signe a - b;
  . ET logique bit à bit: a ET b;
  . OU logique bit à bit: a OU b;
  . L'opérande: b.

Le résultat de l'opération est transmis au registre accumulateur 355 d'une part et à un circuit
logique de test 351 qui reçoit en plus des huit bits
de résultat un bit supplémentaire qui marque:

- le débordement du résultat positif pour une
  addition
- ou le résultat négatif d'une soustraction.

Le résultat sur 8 bits des opérations est stocké dans le registre accumulateur de huit bits dont la sortie est reliée à l'entrée a de l'unité arithmétique et logique 350 comme indiqué ci-dessus, le chargement dans l'accumulateur étant commandé par une horloge accumulateur HACC. La sortie de l'accumulateur peut également être portée sur les huits bits de faible poids du bus de données BD via un "buffer" de sortie 360 commandé par un signal d'activation, SBA. Le bit de plus fort poids MSB est lui mis à zéro.

Le circuit logique de test 351 qui reçoit le signal de sortie de l'unité arithmétique et logique fournit quatre signaux d'état associés au résultat chargé dans l'accumulateur. Un premier signal d'état ANZ indique que l'accumulateur n'est pas à zéro c'est-à-dire qu'au moins un des neuf bits du résultat transmis à l'accumulateur est différent de 0; AZ indique que l'accumulateur est à zéro c'est-à-dire que les neuf bits en sortie de l'unité arithmétique et logique sont tous nuls; AN indique que le résultat du calcul dans l'unité arithmétique et logique est négatif, cet état étant indiqué par le 9ème bit; AIZ indique que le résultat issu de l'unité arithmétique et logique est inférieur ou égal à 0 et donc est le résultat de l'opération logique AZ OU AN actif. Comme il sera indiqué ci-après ces signaux sont décodés par un circuit logique du circuit de commande lors des instructions de branchement conditionnel.

Les instructions de commande de l'opération arithmétique contiennent un champ de cinq bits, <16:15,7:5> dans l'exemple représenté, décodé par un circuit logique de décodage et de commande de synchronisation 370 qui reçoit par ailleurs les deux signaux d'horloge HC et HSC. Le circuit 370 fournit le signal de sélection du multiplexeur 311, SAA, les signaux de commande d'écriture et de lecture dans la mémoire RAM 310, ERA et LRA, le signal d'horloge de commande de l'accumulateur HACC et le signal de commande d'activation du tampon de sortie SBA. Le chronogramme de la figure 7 représente le séquencement des différents signaux de commande générés dans l'opérateur arithmétique. Lorsque des "X" sont mentionnés sur les chronogrammes, les signaux ne sont pas établis.

La figure 3 représente plus en détails l'opérateur Galois 400 de la figure 1. Cet opérateur assure d'une part la mémorisation des données des mots de code, des variables de calcul à valeurs dans le corps de Galois, et assure par ailleurs les opérations polynomiales des algorithmes de codage et de décodage à partir de ces données. Ces fonctions nécessitent une mémoire de forte capacité pour le stockage d'un volume de données important (données d'entrée, données de sortie, ou résultats de calculs intermédiaires). D'une façon générale l'opérateur est structuré de la manière suivante : il comporte deux blocs mémoires qui permettent un double flux de données pour le traitement simple de deux polynômes ou pour le traitement double d'un seul polynôme (avec écriture et lecture simultanées). Pour cela la mémoire est pilotée par une unité d'adressage qui permet la gestion simultanée des entrées-sorties et des calculs polynomiaux. Ces deux unités mémoires permettent d'alimenter un dispositif de calcul spécialisé qui réalise les opérations polynomiales de base dans un corps de Galois paramétrable: division et développement d'un polynôme par un monôme, produit de deux polynômes, valeur d'un polynôme en un point ...

La description qui suit donne un exemple de réalisation détaillé de l'opérateur Galois : les données sont stockées dans deux mémoires RAM, 401 et 402, de capacités égales à 512 mots de neuf bits, dont la page d'adresses 0 à 255, est une zone de calculs et l'autre page aux adresses 256 à 511, constitue les zones de mémoires FIFO de mots de codes pour le stockage des données échangées avec l'extérieur via l'interface. Ces mémoires sont commandées chacune par un signal de commande d'écriture et un signal de commande de lecture, EAG et LAG pour la mémoire 401, et EBG et LBG pour la mémoire 402. Les entrées d'adresses AAG et ABG respectivement sont connectées aux sorties d'une unité d'adressage 410. L'entrée de données de ces mémoires, commune pour les deux, DEG est connectée à la sortie d'un multiplexeur, MD, commandé par un signal de sélection appliqué à son entrée de sélection SEG, et dont les entrées sont connectées respectivement au bus de données BD et à la sortie de résultat Galois RG de l'opérateur.

Les sorties A et B des deux mémoires, respectivement 401 et 402 sont reliées aux deux entrées du dispositif de calcul Galois 420.

L'unité d'adressage des mémoires 402 comporte trois compteurs-décompteurs 411, 412, et 413 qui génèrent les adresses des données nécessaires aux calculs polynomiaux, et deux compteurs 414 et 415 génèrent les adresses des FIFO pour les entrées/sorties de mots de codes. Les compteurs-décompteurs 8 bits, 411, 412 et 413 reçoivent chacun trois signaux de commande :
- un signal de préchargement du compteur PCA, PCB, et PCF respectivement,
- un signal de commande du sens du comptage, IDCA, IDCF, et IDCB respectivement,
- un signal d'horloge de comptage, HCA, HCF, et HCB respectivement.

La sortie du compteur 413 est reliée à un circuit OU 418 qui fournit un signal de test actif CBNN lorsque le contenu du compteur n'est pas nul.

Les compteurs 414 et 415 sont des pointeurs huit bits, commandés par un signal de remise à zéro commun, RZP, et par une horloge de comptage, HPE et HPL respectivement.

Un type d'instruction spécial commande l'opérateur Galois dans son ensemble mais certaines informations "stables" nécessitent deux registres permanents : un registre de commande 416, alimenté par quatre bits de poids faible du bus de données, et commandé par une horloge HRCG :

- le bit de poids le plus élevé RCG <3> commande la page (9$^e$ bit) de l'adresse désignée par le compteur 411
- le bit suivant RCG <2> fixe la page (9$^e$ bit) de l'adresse désignée par le compteur 412
- les deux derniers bits RCG <1,0> constituent le signal SB8 qui commande la sélection du bit de poids le plus élevé du résultat Galois RG issu de l'opérateur Galois, appliqué au multiplexeur M2 comme indiqué ci-après.

Un second registre 417 fixe l'ordre du corps de Galois et est également connecté aux quatre bits de poids faible du bus de données BD et commandé par une horloge HROG. Ce registre 417 fixe

- par son bit de poids le plus élevé ROG <3> le type de code via le test conditionnel RS décrit ci-après;
- les trois autres bits, ROG <2,0> donnent l'ordre du corps de Galois OCG utilisé dans le multiplieur-additionneur du dispositif de calcul de Galois, comme décrit ci-après.

Les éléments décrits ci-dessus permettent d'expliquer le mode d'adressage utilisé dans l'opérateur : les sources de l'adresse AAG de la mémoire 401 sont sélectionnées par un signal de sélection SAAG appliqué à un multiplexeur MA entre:

- le compteur 411, à la page fixée par le registre 416;
- le compteur 412, à la page fixée par le registre 416;
- le pointeur de lecture 414, en page 1

De la même manière les sources de l'adresse ABG de la mémoire 402 sont sélectionnées par un signal de sélection SABG appliqué à un multiplexeur MB entre:

- le comp
- le compteur 412, à la page fixée par le registre 416 ;
- le pointeur d'écriture, 415, en page 1
- ou enfin une adresse directe ADB, de quatre bits issue du bus instruction BI, en page 0.

La partie calcul de l'opérateur Galois est conçue pour réaliser la quasi totalité des opérations polynomiales nécessaires au codage-décodage par les codes BCH ou Reed Solomon par un seul type d'instruction, l'opération réalisée dans les corps de Galois dans le multiplieur-additionneur Galois, MAG, de l'opérateur étant toujours la même. Cette partie calcul 420 permet les opérations polynomiales dans les cinq corps de Galois CG(16) à CG(256). Elle comporte trois registres R0, R1, R2 destinés à fournir trois opérandes X, Y, Z appliqués au multiplieur-additionneur MAG, ces opérandes provenant de plusieurs sources de données possibles. Pour cela le registre R0 est relié à la sortie d'un multiplexeur M0 dont une première entrée est reliée à la sortie A de la mémoire RAM, 401, une seconde entrée est reliée à la sortie du registre R1, et la troisième entrée est reliée à la sortie de résultat R du multiplieur-additionneur. De la même manière le registre R1 est alimenté via un multiplexeur M1 soit par la sortie B de la mémoire RAM 402, soit par la sortie A de la mémoire RAM 401 soit enfin par la sortie de résultat R du multiplieur-additionneur Galois MAG. Pour cette sélection les multiplexeurs M0 et M1 sont commandés par deux signaux de sélection, respectivement SEL0 et SEL1. L'entrée du registre R2 est reliée directement à la sortie B de la mémoire RAM 402. Ces données sont toujours disponibles sur huit bits, le 9ème bit des mots de sortie des mémoires RAM 401 et 402 étant respectivement appliqués à deux registres, RF0 et RF2.

Le chargement des registres R0 et RF0 est commandé par un signal de commande de chargement CR0, le chargement des registres R2 et RF2 est commandé par un signal de chargement CR2, et le chargement du registre R1 est commandé par le signal de chargement CR1. Les registres R0 et R1 comportent également une entrée de remise à zéro, respectivement RZ0 et RZ1. La bascule RF0 génère deux signaux d'états, EFF et VAL respectivement caractéristiques d'un effacement ou au contraire de la validité. La bascule RF2 a sa sortie reliée à la première entrée d'un multiplexeur M2 recevant également le signal de sélection à deux bits SB8 issu du registre 416. Le multiplexeur M2 délivre le bit de validité affecté au résultat R issu du multiplieur-additionneur Galois et constituant le 9ème bit du résultat Galois RG en sortie du dispositif de calcul 420. Ce dispositif comporte en outre un circuit logique de test LO ayant deux entrées reliées aux sorties des registres R0 et R1, ce circuit logique fournissant des signaux d'état fonction à chaque étape de ces registres R0N si le contenu de R0 est nul, R1N si le contenu de R1 est nul, R1NN si le contenu de R1 est non nul, et enfin RNB si le contenu de R1 est non binaire. Ces signaux sont utilisés dans le séquenceur comme il sera décrit ci-après, lors des instructions de branchement conditionnel.

Les signaux d'horloge cyle HC et horloge "sous cycle" HSC ainsi que deux signaux de commande CLNN et BL sont appliqués à un circuit logique de synchronisation 440 qui reçoit également les 17 bits d'instruction transmis sur le bus instruction BI, à chaque étape de calcul. Ce circuit délivre les différents signaux de commande appliqués aux circuits composant l'opérateur Galois pour réaliser les opérations indiquées ci-dessus, c'est-à-dire le stockage des données d'adressage dans les registres de l'unité d'adressage 410, puis le transfert des données nécessaires à l'adressage des mémoires 401 et 402 via les multiplexeurs du circuit d'adressage, le transfert parallèlement des données utiles dans les mémoires, aux adresses fournies par l'unité d'adressage, puis le calcul dans le dispositif de calcul 420 à partir des données soit issues des mémoires RAM 401 et 402, soit prélevées à la sortie du dispositif de calcul lui-même , et transmises au multiplieur-additionneur Galois via les multiplexeurs du dispositif de calcul et les registres, R0, R1 et R2.

Pour certains types d'instructions notamment lors des opérations d'entrées/sorties, les données doivent être transférées telles quelles sur le bus de données BD. Pour cela un multiplexeur supplémentaire 430 a deux entrées multiples reliées d'une part à la sortie A, sur 9 bits, de la mémoire RAM 401, et d'autre part à la sortie en 8 bits du registre R1, le 9ème bit de cette entrée du multiplexeur étant positionné à O. Ce multiplexeur est commandé par un signal de commande SDG et la sortie du multiplexeur est reliée au bus de données BD via un amplificateur formant étage tampon ou "buffer" de sortie commandé par un signal SBG qui valide le transfert des données de sortie du multiplexeur au bus de données BD.

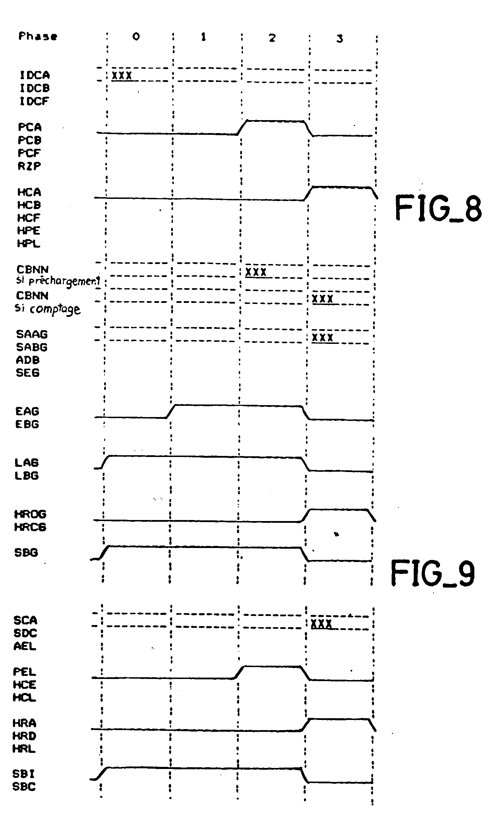

Le chronogramme de la figure 8 représente le séquencement des signaux de commande générés dans l'opérateur Galois décrits ci-dessus.

La figure 4 est le schéma plus détaillé du circuit d'interface 500 représenté sur la figure 1. Le circuit d'interface comporte un circuit logique de décodage et de synchronisation 510 recevant les signaux d'horloge et les 17 bits du bus interne d'instruction BI et fournissant des signaux de commande aux circuits d'interface, et un circuit de décodage 520 des signaux externes, transmis par le processeur hôte et utilisés pour la gestion des échanges. Le circuit d'interface permet au processeur maître extérieur d'accéder aux registres d'interface qui assurent la commande et la connaissance de l'état du codeur-décodeur via un bus de données D par l'intermédiaire duquel s'effectuent également l'écriture des symboles de mots à coder ou à décoder, ou la lecture de mots codés ou décodés par le processeur spécialisé. Les signaux de commande générés par le circuit 520, fonction des signaux externes fournis par le processeur extérieur n'ont pas été représentés sur les figures. Un automate d'accès mémoire indirect gère les transferts de données dans les deux sens avec le processeur maître.

Les registres d'interface délivrent leurs valeurs sur un bus de sortie de données DS, données qui sont alors chargées sur le bus extérieur de l'interface D via un "buffer" de sortie 555 commandé par un signal de commande SBE. En écriture ces registres d'interface mettent en mémoire la donnée présente sur un bus interne DE reçue du bus D via un "buffer" d'entrée 550 lorsqu'un signal de commande appliqué à ce "buffer" EBE est actif.

Parmi les registres d'interface on dispose tout d'abord d'un registre de commande 501 qui contient le mot de commande du circuit. En écriture ce registre est chargé par la donnée présente sur la ligne DE, sur le front descendant de l'horloge HRC qui lui est appliqué et qui active aussitôt le signal de requête d'interruption RI et positionne le signal de test FCT à la valeur vraie pour signifier une remise à zéro d'interruption, ces deux signaux étant transmis au circuit de commande 100. En lecture la valeur contenue dans ce registre est délivrée sur le bus de sortie DS quand le signal de commande SRC appliqué à un tampon de sortie 507 relié à la sortie du registre 501 est actif. Le signal RESET, résultat de l'échantillonnage de la broche extérieure RST commande la remise à zéro du registre 501 et désactive le test FCT issu du circuit de décodage des signaux externes 520.

En plus de ce registre de commande 501, le circuit d'interface comporte des registres pour la mise en mémoire d'un mot d'état : un registre d'état 511, à quatre bits, connecté au bus de données interne BD et chargé sur l'instruction par l'activation du signal d'horloge HRA, et forcé à 0 par le signal RESET, et deux registres 1 bit d'état 512, et 513, issus de l'automate d'accès mémoire indirect décrit ci-après. En plus des deux bascules 1 bit 512 et 513, le circuit automate d'accès mémoire indirect comporte deux registres 8 bits, 521 et 531. Les informations issues de ces différents circuits, 511, 512, 513, 521 et 531 peuvent être transférées sur le bus de données de sortie DS, mais ces informations peuvent être modifiées par le programme interne pendant un cycle de lecture extérieure. Pour cela des registres de bascules 515 associé aux registres 512, 513 et 511, 525 associé au registre 521, et 535 associé au registre 531 sont interposés entre ces registres et le bus de sortie DS. Chacune de ces bascules charge la valeur du registre réel sur le front actif du signal d'horloge HC qui leur appliqué, sauf pendant un cycle de lecture extérieure où le bit de sélection correspondant, respectivement SRA, SCE, et SCL est actif, et délivre la valeur de cette bascule sur le bus de données de sortie DS. Ces sorties se font via des "buffer" de sortie, respectivement 516, 526, 536.

De plus, un registre vecteur d'interruption 502 est accessible en écriture et lecture directes, ou sur un cycle d'acquittement. Pour l'écriture il est relié au bus de données d'entrée DE et charge la donnée correspondante sur le front descendant de l'horloge HRV qui lui est appliqué. Pour la lecture, ce registre 502 est relié au bus de données de sortie (DS via un tampon de sortie 508 commandé par un signal SRV.

Le circuit d'interface comporte en outre un registre d'effacement un bit, 503 dont l'entrée est reliée au bus DE et la sortie à une entrée un bit d'un circuit logique 505. Le registre d'effacement est commandé par une horloge HRF qui commande le chargement du bit de faible poids de la donnée présente sur le bus DE sur son front descendant.

Un registre d'écriture de données 504 est également relié à l'entrée de données DE et en écriture charge la valeur 8 bits présente sur ce bus sur le front descendant de l'horloge HRE qui lui est appliqué. La sortie de ce registre est reliée à une entrée multiple sur 8 bits du circuit logique 505. Ce circuit 505 a enfin une entrée 1 bit reliée à une sortie 1 bit Q du registre de commande 501. Le mot de données de 9 bits transmis sur le bus de données BD via le circuit logique 505 et un "buffer" de sortie 506 sur commande SBI, comporte les 7 bits de faible poids du mot de 8 bits mis en mémoire dans le registre 504, et les deux bits de plus fort poids sont fonction du mode d'entrée des données, indiqué par le bit Q, du contenu du registre 503 et des valeurs des bits de poids le plus élevé du mot de données.

Pour la lecture des données présentes sur le bus de données BD, le circuit d'interface comporte en outre un registre de lecture 545 qui délivre la donnée présente sur le bus interne BD sur le bus de sortie DS via un "buffer" de sortie 546 activé par un signal de commande SRL. Ce registre de lecture est chargé par activation de l'horloge HRL qui lui est appliqué, lors d'instructions qui seront définies ci-après.

La lecture du contenu du registre de lecture 545 ou l'écriture dans le registre d'écriture 504, et l'activation du signal de requête de transfert RT, ne sont validées que si le bit d'état correspondant au sens de transfert ST est actif. Pour cela le signal extérieur R/$\overline{W}$ est échantillonné en tant que source du signal du sens de transfert ST. Ces opérations sont commandées par un signal d'horloge HRT.

Comme indiqué ci-dessus, en plus des registres affectés au transfert des données, le circuit d'interface comporte un automate d'accès mémoire indirect. Cet automate compte le nombre de transferts réalisés entre les registres de données d'interface 504 et 545 et les mémoires internes 401 et 402 à partir d'un état initial provoqué par une instruction spécifique comme il sera expliqué ci-après. Les deux registres 521 et 531 comptent le nombre de données accessibles en écriture ou en lecture respectivement quand le bit d'état correspondant issu des bascules 512 et 513 respectivement, est actif. Ces compteurs 521 et 531 peuvent être initialisés à la valeur maximum "FF" ou déplacés individuellement d'une valeur calculée par le programme. Lors d'une instruction d'adressage mémoire indirect , le compteur correspondant au sens de transfert est décrémenté comme il sera précisé ci-après. Les déplacements de compteurs par le programme permettent de cumuler le nombre de transferts possibles, compte tenu de ceux qui ont été réalisés et facilitent ainsi le dialogue entre le processeur spécialisé et le processeur extérieur, contrairement à ce qui se passe habituellement lors d'échanges par blocs figés.

L'automate d'accès mémoire indirect comporte en plus des compteurs 521 et 531 et des bascules d'états 512 et 513 associées, un additionneur 560 8 bits, non signé, dont la sortie est reliée aux entrées des compteurs 521 et 531. Cet additionneur a une entrée 1 reliée à la sortie 8 bits d'un multiplexeur 561, ce multiplexeur ayant deux entrées respectivement reliées aux sorties des compteurs d'écriture 521 et de lecture 531, et une entrée de signal de commande SCA qui sélectionne l'une ou l'autre des sorties des compteurs. La seconde entrée, 2, de l'additionneur 560 est reliée à la sortie d'un multiplexeur 562 commandé par un signal SDC, qui a deux entrées : l'une pour décrémenter les compteurs d'une unité par addition de "FF", et l'autre couplée à la sortie sur 8 bits d'un registre de déplacement 570 commandé par une horloge de déplacement HRD, l'entrée du registre 570 étant reliée au bus interne de données BD. Ainsi sur l'entrée 2 de l'additionneur 560, la commande SDC sélectionne la valeur "FF" pour réaliser une décrémentation lors d'une instruction d'accès mémoire indirect, ou pour additionner le contenu du registre de déplacement 570, pour un déplacement programmé du compteur. Ces compteurs 521 et 531 sont deux registres 8 bits qui chargent le résultat de l'additionneur sur activation des horloges respectivement HCE et HCL, et qui peuvent être initialisés à la valeur maximum "FF" par la commande de préchargement PEL qui leur est appliquée. Comme indiqué ci-dessus, à chaque compteur est associé un bit de validité mis en mémoire dans les bascules 512 et 513 sur commande HCE et HCL, et qui peuvent être mis à zéro par la commande PEL qui leur est également appliquée. Le bit de validité appliqué à ces registres 512 et 513 est soit la retenue issue de l'additionneur 560 lors d'une décrémentation, soit la valeur 1, par l'intermédiaire d'un signal de commande AEL, ces deux signaux étant appliqués aux entrées d'une porte OU 565 dont la sortie est reliée aux entrées des registres 512 et 513.

La lecture du contenu de l'un des compteurs 521 ou 531 sur le bus de données interne BD est réalisée par l'activation de la commande SBC appliquée au tampon de sortie 563 relié à la sortie du multiplexeur 561. La procédure de vol de cycle permet la commande intégrale de l'automate d'accès mémoire indirect, par le bus d'instructions BI, dans le but de simplifier la structure de commande du circuit.

Par ailleurs un circuit logique de test, 564 reçoit les bits de validité d'écriture et de lecture en sortie des registres 512 et 513 et les contenus des compteurs écriture et lecture 521 et 531, et définit à partir de ces signaux des signaux de test qui permettent la commande des mémoires et la gestion du séquenceur:

- FEV qui indique que la mémoire d'écriture est vide, lorsque le bit de validité issu de la bascule 512 est égal à 1 et que le contenu du compteur d'écriture est au maximum;
- FLP qui indique que la mémoire de lecture est pleine, c'est-à-dire qui est validé lorsque la bascule 513 est à 1 et que le contenu du compteur de lecture 531 est au maximum.

Le circuit logique de test 564 transmet tel quel le bit de validité lecture issu du registre 513, et un signal indiquant que le compteur de lecture 531 a un contenu non nul, CLNN.

La figure 9 est un chronogramme des signaux de commande décrits ci-dessus générés dans le circuit d'interface.

Le circuit de commande représenté sur la figure 5 intègre le séquenceur du processeur spécialisé, et gère l'ensemble du codeur-décodeur.

En plus des modes cla ssiques d'un séquenceur, branchement conditionnel etc..., le séquenceur de ce processeur spécialisé comporte en particulier un système de boucle automatique, particulièrement adapté aux algorithmes polynomiaux, et dont le fonctionnement est "transparent" dès la fin d'une instruction d'initialisation. Cette procédure permet de décrire n fois (n étant inférieur ou égal à 256) une boucle de p instructions (p inférieur ou égal à 16) après un délai de m instructions (m inférieur ou égal à 8), et en ne "perdant" qu'une seule instruction d'initialisation.

Ce circuit de commande reçoit les signaux d'horloge HC et HSC du générateur d'horloge 200, les signaux de test issus de l'opérateur arithmétique 300 et de l'opérateur Galois 400 et des signaux de commande issus de l'interface 500. Ces signaux sont appliqués à un circuit logique de commande 150 qui génère des signaux logiques de commande à destination des autres circuits du circuit de commande. Ce circuit comporte en outre un ensemble de gestion de la boucle automatique qui comporte:

- un compteur de délai 101 à trois bits, qui décompte les instructions avant la première instruction du corps de la boucle. Ce compteur reçoit les deux bits de rang 10 et 11 du bus instruction, une horloge de comptage HDEL, et deux signaux de commande, l'un de remise à zéro RZCBA et l'autre de préchargement PCBA. Ce compteur fournit un signal de sortie DELAO appliqué au circuit logique de commande lorsque son contenu est nul.
- un compteur de boucles d'instructions 102 qui reçoit une horloge de comptage de boucles d'instructions HCBI et un signal de préchargement du compteur de boucles d'instructions PCBI issu du circuit logique de commande, et le contenu d'un registre de boucles d'instructions 103 commandé par un champ instruction de 3 bits en provenance du bus d'instructions BDI, <14:12>, et commandé par un signal de préchargement PRBI issu du circuit logique de commande. Ainsi le compteur de boucles d'instructions 102 décompte les instructions du corps de boucle et est automatiquement rechargé à la fin du corps de boucle avec la valeur du registre de boucle instruction 103 qui met en mémoire la longueur du corps de boucle.
- Un compteur 8 bits de boucles de répétition, 104, qui décompte le nombre de fois où le corps de boucle doit être exécuté, et qui reçoit 8 bits du bus de données BD, un signal de remise à zéro RZCBA issu du circuit logique de commande, un circuit de préchargement PCBA et une horloge de comptage de boucles de répétition HCBR, tous trois issus du circuit logique de commande. Ce compteur envoie un signal de commande au circuit logique 150 lorsque son contenu est nul, CBRAO. Lorsque le compteur de boucle 104 est initialisé à zéro la boucle est réalisée une seule fois.

L'instruction d'initialisation de la boucle automatique charge les compteurs 101 et 102 par une valeur issue de l'instruction, et le compteur 104 par les 8 bits de faible poids du bus de données BD qui porte alors la valeur de l'accumulateur 355 de l'opérateur arithmétique; le signal de chargement des compteurs de boucle automatique CCBA issu d'une porte ET 105 à laquelle est appliqué le champ d'instruction BI<16,15,4:0> est alors actif.

Le circuit de commande comporte en outre un compteur programme 110, à 10 bits, qui présente l'adresse de l'instruction suivante. Pour cela, ce compteur 10 bits a son entrée reliée via un multiplexeur 111 à la sortie d'un registre d'adresse de boucle 112 qui présente l'adresse de début de boucle automatique. Le multiplexeur reçoit également une adresse dite adresse immédiate, présente sur 10 des bits du bus instruction, BI<14:5>. Ce compteur programme 110 peut également être mis à 0 via une entrée de mise à zéro du multiplexeur, et peut également subir une itération au moyen d'un additionneur recevant le contenu du compteur de programme 110 auquel elle ajoute 1, la sortie de cet additionneur 113 étant reliée à une quatrième entrée du multiplexeur 111. L'entrée du regi boucle 112 est également reliée à la sortie du compteur de programme 110. Le compteur de programme 110 reçoit un signal d'horloge HCP issu du circuit logique de commande 150 ; le multiplexeur 111 reçoit un signal de commande SCP également issu du circuit logique de commande 150 ; et le registre d'adresse de boucle 112 reçoit un signal de commande de chargement PRAB issu de ce même circuit.

Enfin, le circuit de commande comporte également un ensemble de gestion du bus d'instructions qui comprend:

- une mémoire de programme 120, ROM, de capacité 1024 mots de 17 bits reliée à la sortie du compteur de programme CP, et dont la sortie est reliée à l'entrée d'un registre d'instruction 122 via un multiplexeur 121. Le registre d'instruction 122 présente l'instruction à exécuter, sur le bus instruction, via un tampon de sortie 123. En séquencement programme, le registre instruction 122 charge la valeur issue de la mémoire programme 120 mais une instruction prioritaire peut prendre sa place, sur commande SIP issue du circuit logique de commande, dans certains cas.

Le circuit logique de commande génère un signal d'acquittement AT et un signal AI à destination du circuit d'interface 500. Enfin un transfert de données du bus instruction BI au bus de données BD peut être effectué sur commande SBC issu du

L'architecture du codeur-décodeur algébrique décrit ci-circuit logique de commande, via un tampon de sortie 130. dessus permet d'optimiser le fonctionnement pour le codage et le décodage de codes en blocs. La description ci-après qui précise quelques points particuliers du fonctionnement interne de ce codeur-décodeur va permettre de mettre en évidence ces avantages.

Il a été indiqué ci-dessus que ce codeur-décodeur permettait des interruptions internes et des transferts de données par accès mémoire indirect:

Une interruption interne est activée chaque fois que le processeur de gestion émet un mot de commande dans le registre de commande 501 du circuit d'interface. La remise à zéro du seul séquenceur déroute le programme à l'adresse h00.

Ce mécanisme permet de conserver les informations utiles pour les traitements à suivre qui sont présentes dans les différentes mémoires du circuit.

En ce qui concerne le transfert de données par accès mémoire indirect, chaque accès sur l'un des registres d'interface écriture ou lecture, 504 et 545 engendre une requête de transfert, c'est-à-dire l'activation du signal RT par le module d'interface. Cette requête, validée par le bit issu du registre 512 ou du registre 513 respectivement en écriture ou en lecture suivant le sens de transfert désigné par le signal ST, est activée par le circuit d'interface et transmise au module de commande qui l'acquitte par le signal AT dès la fin de l'instruction en cours d'exécution.

Ainsi le circuit logique de commande 150 est activé par les signaux RT et ST pour "voler" au plus vite un cycle au programme en cours d'exécution qui force une instruction prioritaire de type accès mémoire indirect (AMI). Suivant le sens de transfert ST cette instruction particulière réalise:

1) un accès mémoire indirect en écriture (AMIE) soit:

- le transfert de la donnée présente dans le registre d'écriture 504 à la mémoire 402, à l'adresse indiquée par le pointeur d'écriture 415;

- la post-incrémentation du pointeur d'écriture 415

- la post-décrémentation du compteur d'écriture 521 du circuit d'interface.

2) Un accès mémoire indirect en lecture (AMIL) c'est-à-dire :

- le transfert de la donnée présente dans la mémoire 401 à l'adresse indiquée par le pointeur de lecture 414 dans le registre de lecture 545;

- la post-incrémentation du pointeur de lecture 414, si et seulement si le contenu du compteur de lecture 531 est différent de 0 (l'étage de pipe line en lecture nécessite ce contrôle du pointeur de lecture 414 pour ne pas perdre une donnée quand la mémoire FIFO est vide à l'is sue de ce dernier transfert);

- la post-décrémentation du compteur de lecture 531.

Comme indiqué ci-dessus, le codeur-décodeur de codes en blocs qui vient d'être décrit est un processeur spécialisé qui intègre un opérateur câblé réalisant la multiplication addition dans cinq corps de Galois, de CG(16) à CG(256). Cette structure permet de mettre en oeuvre les algorithmes de codage et de décodage les plus courants, à l'exception de ceux qui utilisent des traitements logarithmiques ou des inverses pour lesquels ce processeur n'est pas optimisé, le calcul de l'inverse ou du logarithme d'un élément nécessitant au plus une boucle de la taille du corps de Galois. Mais des modifications simples des algorithmes classiques permettent d'éviter ce type de calcul. Les principaux algorithmes de codage et de décodage des codes BCH et Reed Solomon sont décrits dans les documents suivants:

- "Error Correcting Codes" de PETERSON et WELDON (MJT Press 1972)
- "Algebraic Coding Theory" de BERLEKAMP, Mc GRAW HILL, 1968.

Ces algorithmes mettent en oeuvre des fonctions polynomiales élémentaires, telles que la division ou le produit d'un polynôme par un monôme du type (1 + az) ou (a + z) et le calcul des coefficients de produit de deux polynômes, qui sont implantés facilement dans ce processeur grâce à la boucle automatique du séquenceur et au chemin de données optimisé dans l'opérateur Galois. Ces différents algorithmes sont implémentés en mémoire programme 120 suivant un microcode défini pour ce processeur. Ce microcode comprend dans l'exemple décrit quatre types d'instructions qui sont différenciés par les bits de plus fort poids, toute instruction étant comme décrit ci-dessus codée sur 17 bits, BI<16:0>. Le champ type de deux bits <16,15> fixe la répartition des autres champs de l'instruction. A titre d'exemple ces instructions peuvent être les suivantes:

- type 1: instruction valeur immédiate :

    cette instruction réalise une des actions suivantes :

    a) le chargement d'une valeur immédiate de 8 bits, VIM définie par le champ <6:14> de l'instruction, dans la mémoire RAM 310 de l'opérateur arithmétique, à l'adresse du champ CCM défini par les cinq bits de faible poids de l'instruction <4:0>.

    b) le chargement d'une valeur immédiate de 9 bits, <14:6> à une destination déterminée par le champ CCM <4:0> de l'instruction.

    c) l'instruction d'initialisation de l'accès mémoire indirect correspondant à un code spécifique CCM ; cette opération annule les pointeurs d'écriture et de lecture, 414 et 415 et initialise les compteurs de l'automate d'accès mémoire indirect 512, 513 et 521, 531.

- type 2: instruction opérateur arithmétique: cette instruction réalise une des actions suivantes:

    a) une opération arithmétique entre le contenu de l'accumulateur 355 et la valeur issue de la mémoire 310 de l'opérateur arithmétique 310, à l'adresse ARA donnée par les bits <14:10> de l'instruction correspondante, avec ou non un transfert de la valeur antérieure contenue dans l'accumulateur, 355, à une destination fixée par le champ CCM, BI<4:0>

    .

    b) le transfert d'une valeur issue soit de l'accumulateur 355, soit de l'une des sources du bus de données BD sélectionnée par le champ CCM de l'instruction, dans la mémoire 310 de l'opérateur arithmétique à l'adresse, ARA, précisée par le champ BI<14:10>.

    c) une instruction de déplacement de compteur :

    - le déplacement du compteur d'écriture 521 : cette instruction réalise l'addition du contenu du registre de déplacement 570 au contenu du compteur d'écriture 521 et active le bit d'écriture issu de la bascule 512.

    - le déplacement du compteur de lecture 531 : cette instruction réalise l'addition du contenu du registre de déplacement 570 au contenu du compteur de lecture 531 et active le bit de lecture issu de la bascule 513. Si le bit de lecture es ndirect de lecture en chargeant le registre de lecture 545 avec la donnée présente dans la mémoire 401 à l'adresse du pointeur de lecture associé, 414, qui est ensuite post-incrémenté.

    d) l'initialisation des trois compteurs de boucle automatique du séquenceur, 101, 102 et 104, les valeurs transmises aux compteurs 101 et 102 provenant de la micro-instruction champs <11:10> et <14:12> respectivement, tandis que celle chargée dans le compteur 104 est issue de l'accumulateur 355 de l'opérateur arithmétique, via le bus de données BD<7:0>.

- type 3: instruction d'opération Galois: cette instruction commande l'opérateur Galois 400, c'est-à-dire

    a) l'écriture ou la lecture des mémoires 401 et 402,

    b) l'adressage de ces mémoires et les modifications des compteurs d'adresses,

    c) la sélection des opérandes et la commande des registres R0, R1, R2 du dispositif de calcul Galois, 420.

- type 4: instruction de branchement: cette instruction réalise le branchement conditionnel du programme suivant la valeur de l'un de 16 tests conditionnels réalisé sur le mot de test de l'opérateur arithmétique (4 bits), le mot de test de l'opérateur Galois (8 bits), les 3 bits de test de l'interface (FLP, FEV et FCT) et un 16 $^e$ bit lorsqu'une condition est toujours vraie.

Pour l'accès mémoire indirect, des instructions du type 1, instruction d'opération arithmétique réalisent les transferts de données.

Pour l'accès mémoire indirect en écriture, l'instruction réalise les actions suivantes :

a) le transfert de la donnée du registre 504 à la mémoire 402, à l'adresse donnée par le pointeur d'écriture 415 ;

b) la post-incrémentation du pointeur 415 ;

c) la post-décrémentation du compteur d'écriture 521

Pour l'accès mémoire indirect en lecture, l'instruction réalise les actions suivantes :

a) le transfert du contenu de la mémoire 401 à l'adresse du pointeur de lecture 414 dans le registre de lecture 545 ;

b) la post-incrémentation du pointeur de lecture 414 si et seulement si le contenu du compteur de lecture 531 est différent de 0. Ce contrôle est nécessaire pour ne pas perdre une donnée quand la partie FIFO de lecture de la mémoire 401 est vide ;

c) la post-décrémentation du compteur 531.

L'écriture précise des instructions nécessaires est à la portée de l'homme de l'art et ne sera donc pas détaillée ici.

Par ailleurs, le processeur hôte peut contrôler l'état du périphérique par une lecture transparente du mot d'état.

Les principes d'échange de données du codeur-décodeur visent à libérer le processeur hôte de toute contrainte autre que le temps des tâches spécifiques au traitement des codes. Ce qui est possible par la structure des mémoires internes du circuit 401 et 402 en deux parties mémoires de 256 mots consacrés l'une à l'écriture de nouvelles données, l'autre à la lecture des données traitées qui ne sont pas adressées directement par le processeur hôte, mais alimentées et vidées via deux registres d'interface d'écriture et de lecture 504 et 545.

Comme expliqué ci-dessus, ces registres permettent au processeur hôte de réaliser des échanges de données transparents pour le périphérique grâce à la procédure interne de vol de cycle. Ainsi, après toute écriture de donnée par le (processeur hôte, un cycle est volé pour transférer cette donnée du registre d'écriture à la mémoire. En lecture, le fonctionnement est identique à la différence que le transfert entre la mémoire et le registre de lecture prépare la donnée de l'échange suivant (pipe-line en lecture).

Ce dispositif permet de désynchroniser les tâches du processeur hôte et du codeur-décodeur et limite le protocole d'échange de données à la seule connaissance de l'état des mémoires. Dans ce but, le mot d'état précise si chacune des sible, et les deux compteurs 521 et 531 donnent le nombre de données pouvant être échangées en lecture et en écriture.

La fréquence maximum de l'horloge du codeur-décodeur, 10 MHz, permet d'atteindre des débits utiles compris entre 100 et 200 kbits/s pour des codes de redondance 2. La capacité mémoire est suffisante pour traiter de tels codes type Reed Solomon avec une taille de symboles de 4 à 8 bits, et type BCH jusqu'à une longueur de 255 bits.

**Revendications**

1. Codeur-décodeur algébrique de codes en blocs Reed Solomon et BCH, applicable aux télécommunications numériques et conçu comme un processeur spécialisé, comportant un générateur d'horloges (200), un opérateur arithmétique (300) traitant les valeurs arithmétiques nécessaires aux algorithmes correspondants, un opérateur de Galois (400) traitant des valeurs dans des corps de Galois, un circuit de commande (100) gérant l'ensemble du codeur-décodeur, et un circuit d'interface (500) pour gérer les transferts de données vers l'extérieur, reliés par un bus de données (BD) et un bus d'instruction (BI), caractérisé en ce que :

- l'opérateur de Galois (400) comporte un opérateur polynomial dans les corps de Galois (420) de 16 à 256 éléments, lequel est spécialisé dans l'exécution répétitive d'une instruction unique $X+(Y^*Z)$, deux mémoires (401, 402) dont les entrées sont couplées au bus de données (BD) et à une sortie de résultats de l'opérateur polynomial (420) et dont les sorties sont reliées à des entrées correspondantes de l'opérateur polynomial (420) lesdites mémoires (401, 402) étant adressables et pilotées par une unité d'adressage (410) soit en mémoires de calcul soit en mémoires d'entrées/sorties FiFo en liaison avec le le circuit d'interface (500) qui comporte des registres affectés au transfert des données et qui un automate d'accès mémoire indirect commandé par le bus instruction (BI) selon une procédure de vol de cycle à un processeur maître extérieur réalisée par le circuit de commande (100), les entrées/sorties étant ainsi exécutées par ladite procédure de vol de cycle afin de ne pas entraver l'exécution des instructions nécessaires au codage-décodage, et en ce que

- le circuit de commande (100) comporte un circuit de gestion de boucle automatique (101, 102, 104) dont l'initialisation par une instruction d'initialisation contenant des valeurs de paramètres m, p, n, commande automatiquement dans l'opérateur de Galois (420), via un circuit logique de commande (150) et le bus d'instruction (BI), n répétitions d'une boucle de p instructions après un délai de m instructions, chaque instruction étant du type $X + (Y^*Z)$.

2. Codeur-décodeur selon la revendication 1, caractérisé en ce que l'opérateur arithmétique (300) a une structure réduite à une mémoire (310), une unité arithmétique et logique (350) dont une première entrée est reliée à la sortie de la mémoire (310) et dont l'autre entrée est directement reliée à la sortie d'un accumulateur (355) également relié au bus de données et dont l'entrée est reliée à la sortie de l'unité arithmétique, l'adressage de la mémoire (310) et la commande d'opération dans l'unité arithmétique et logique étant directement effectués par le bus instruction (BI).

3. Codeur-décodeur selon la revendication 2, caractérisé en ce que les deux mémoires (401, 402) de l'opérateur Galois sont séparées chacune en deux pages mémoire, l'une utilisé en FIFO pour les entrées/sorties de données, et l'autre réservée au calcul et notamment au stockage de valeurs intermédiaires.

4. Codeur-décodeur selon la revendication 3, caractérisé en ce que les entrées/sorties via le circuit d'interface (500) sont réalisées de manière dynamique en fonction des données à lire pour transmission à l'extérieur, ou à écrire pour traitement à l'intérieur du circuit, l'automate accès mémoire indirect du circuit d'interface (500) comportant un registre compteur d'écriture (521) et un registre compteur de lecture (531) associés respectivement aux zones mémoires réservées respectivement à l'écriture et à la lecture des données

## Claims

1. An algebraic encoder-decoder for codes arranged in Reed Solomon and BCH blocks, applicable to digital telecommunications and deviced as a specialized processor, comprising a clock generator (200), an arithmetic operator (300) processing the arithmetic values needed for the corresponding algorithms, a Galois-operator (400) processing the values in main parts of said operator, a control circuit (100) managing the encoder-decoder assembly, and an interface circuit (500) for managing the transfers of data towards the exterior, these items being interconnected by a data bus and an instruction bus (BI), characterized in that

- the Galois-operator (400) comprises a polynomial operator (420) of 16 to 256 elements in the main parts of the Galois-operator, said operator being specialized in the repetitive execution of a single instruction $X + (Y^*Z)$, two memories (401, 402), whose inputs are coupled to the data bus (BD) and to an output of the results provided by the polynomial operator (420), and whose outputs are connected to corresponding inputs of the polynomial operator (420), said memories (401, 402) being addressable and run by an addressing unit (410) either as computation memories or else as input/output memories operating in the FIFO-mode and in connection with the interface circuit (500), which includes registers dedicated to the transfer of data and an automate for providing indirect memory access and controlled by the instruction bus (BI) according to a procedure of cycle shifting towards an external master processor which procedure is implemented by the control circuit (100), the inputs/outputs thus being executed by said cycle shifting procedure so as not to obstruct the execution of instructions needed for encoding-decoding, and

- the control circuit (100) includes an automatic loop management circuit (101, 102, 104) whose initialization by an initialization instruction containing parameter values m, p, n triggers automatically in the Galois-operator and via a logic instruction circuit (150) and the instruction bus (BI) n repetitions of a loop of p instructions after a delay of m instruction, with each instruction being of the type $X + (Y^*Z)$.

2. An encoder-decoder according to claim 1, characterized in that the arithmetic operator (300) has a structure which is reduced to a memory (310), an arithmetic and logic unit (350), of which one first input is connected to the output of the memory (310) and whose other input is directly connected to the output of an accumulator (355) equally connected to the data bus and whose input is connected to the output of the arithmetic unit, the addressing of the memory (310) and the operation control inside the arithmetic and logic unit being directly performed by the instruction bus (BI).

3. An encoder-encoder according to claim 2, characterized in that the two memories (401, 402) of the Galois-operator are subdivided each into two memory pages, one being used in the FIFO mode as to the inputs/outputs of data, and the other being reserved for the computation and notably for the storage of the intermediate values.

4.  An encoder-decoder according to claim 3, characterized in that the input/output operations via the interface circuit (500) are performed in a dynamic manner according to the data to be read for external transmission or to be written for processing in the circuit, the automat for providing indirect memory access of the interface circuit (500) comprising a write counter register (521) and a read counter register (531) associated respectively with the memory zones respectively reserved for writing and reading the data.

## Patentansprüche

1.  Algebraischer Kodierer-Dekodierer für Kodes in Form von Reed Solomon und BCH-Blöcken, der bei digitalen Fernmeldesystemen anwendbar ist und als spezialisierter Prozessor konstruiert ist, mit einem Taktgenerator (200), einem Rechenoperator (300), welcher die für die entsprechenden Algorithmen benötigten Rechenwerte bearbeitet, einem Galois-Operator (400), der Werte im Galois-Hauptteil bearbeitet, einer Steuerschaltung (100) für die gesamte Betriebssteuerung des Kodierers-Dekodierers und mit einer Schnittstellenschaltung (500) zur Durchführung der Datenübertragungen nach außen, wobei diese Komponenten durch einen Datenbus (BD) und einen Befehlsbus (BI) miteinander verbunden sind, dadurch gekennzeichnet, daß

- der Galois-Operator (400) im Galois-Hauptteil (420) einen Polynomoperator von 16 bis 256 Elementen, der auf die wiederholte Ausführung eines einzelnen Befehls $X + (Y^*Z)$ spezialisiert ist, und zwei Speicher (401, 402) aufweist, deren Eingänge an den Datenbus (BD) und an einen Ergebnisausgang des Polynomoperators (420) und deren Ausgänge an die entsprechenden Eingänge des Polynomoperators (420) angeschlossen sind, wobei die Speicher (401, 402) adressierbar sind und durch eine Adressiereinheit (410) entweder als Rechenspeicher oder als FIFO-Eingangs-/Ausgangsspeicher gefahren werden, und zwar in Verbindung mit der Schnittstellenschaltung (500), die Register für die Datenübertragung und einen Automaten für indirekten Speicherzugriff aufweist, der vom Befehlsbus (BI) entsprechend einem durch die Steuerschaltung (100) realisierten Verfahren der Zyklusverschiebung zu einem äußeren Leitprozessor gesteuert wird, wobei die Eingaben/Ausgaben durch das Zykluzsverschiebungsverfahren abgewickelt werden, um nicht die Ausführung der für die Kodierung-Dekodierung benötigten Befehle zu behindern, und

- die Steuerschaltung (100) eine automatische Schleifenbetriebsschaltung (101, 102, 104) aufweist, deren Initialisierung durch einen Initialisierungsbefehl mit Parameterwerten m, p, n im Galois-Operator (420) automatisch über eine logische Steuerschaltung (150) und den Befehlsbus (BI) n Wiederholungen einer Schleife mit p Befehlen nach einer Zeitspanne von m Befehlen auslöst, wobei jeder Befehl vom Typ $X + (Y^*Z)$ ist.

2.  Kodierer-Dekodierer nach Anspruch 1, dadurch gekennzeichnet, daß der Rechenoperator (300) eine Struktur besitzt, die sich auf einen Speicher (310) und eine Logik- und Recheneinheit (350) reduziert, deren erster Eingang an den Ausgang des Speichers (310) und deren zweiter Eingang direkt an den Ausgang eines Akkumulators (350) angeschlossen sind, welcher außerdem mit dem Datenbus verbunden ist und dessen Eingang an den Ausgang der Recheneinheit angeschlossen ist, wobei die Adressierung des Speichers (310) und die Operationssteuerung in der Logik- und Recheneinheit direkt über den Befehlsbus (BI) bewirkt wird.

3.  Kodierer-Dekodierer nach Anspruch 2, dadurch gekennzeichnet, daß die beiden Speicher (401, 402) des Galois-Operators jeweils in zwei Speicherseiten aufgeteilt sind, von denen eine für die Eingaben/Ausgaben von Daten in FIFO-Modus verwendet wird, und die andere für die Berechnung und insbesondere Speicherung von Zwischenwerten reserviert ist.

4.  Kodierer-Dekodierer nach Anspruch 3, dadurch gekennzeichnet, daß die Eingaben/Ausgaben über die Schnittstellenschaltung (500) dynamisch in Abhängigkeit von den für die Übertragung nach außen auszulesenden oder für die Bearbeitung innerhalb der Schaltung einzuschreibenden Daten durchgeführt werden, wobei der Automat für den indirekten Speicherzugriff der Schnittstellenschaltung (500) einen Schreibregisterzähler (521) und einen Leseregisterzähler (531) aufweist, die mit den für das Schreiben bzw. das Lesen der Daten reservierten Speicherzonen verbunden sind.

FIG_1

FIG_2

EP 0 267 836 B1

FIG_3

EP 0 267 836 B1

FIG_4

# FIG_5

EP 0 267 836 B1

FIG_6

FIG_7

FIG_8

FIG_9